# EUROPEAN PATENT APPLICATION

(11) **EP 0 694 966 A1**
(43) Date of publication of application: **31.01.1996**
(21) Application number: 94830391.2
(22) Date of filing: 29.07.1994
(51) Int. Cl.: H01L 23/495, H01L 23/31

(54) **Package for an electronic semiconductor circuit**

(71) Applicant: SGS-THOMSON MICROELECTRONICS S.r.l., I-20041 Agrate Brianza (Milano) (IT)
(72) Inventor: Wilson, Ian, c/o SGS-Thomson Microelec. S.r.l., I-95121 Catania (IT)
(74) Representative: Checcacci, Giorgio

(57) **Abstract**

A power package of the type comprising in a body-shell (2) of synthetic plastic material at least one electronic circuit provided on a semiconductor chip (7) fastened on a lead frame (4) and a heatsink (5) in contact with said semiconductor chip (7) also provides a surface groove (11) formed in the body-shell (2) of synthetic plastic material.

Said groove (11) allows absorption of the tensile stresses due to the phase of solidification of the heat-hardening resin forming the body-shell (2).

## Description

### Field of application

The present invention relates to an improved package for an electronic semiconductor circuit.

The inventions concerns in particular but not exclusively a so-called power package incorporating a discrete semiconductor component with related heat dissipator. The principles of the invention concern however also those packages incorporating analog or digital integrated circuits and the following description is given with reference to this field of application with the only purpose of simplifying the discussion thereof.

### Known art

As known, in the specific field of application of the present invention there is a requirement to provide the semiconductor package equipping it with a dissipator element or heatsink.

The heatsink is nothing but a metal element or in any case a good heat conductor which has mass decidedly greater than that of the integrated semiconductor circuit and is placed in contact with the latter to facilitate dispersal of the heat during operation of the circuit.

The typical structure of a semiconductor package is shown schematically in the annexed figures from 1 to 5 which illustrate in enlarged scale and vertical cross section an embodiment thereof in accordance with the known art and specifically in accordance with a process known as "drop-in".

With reference to said FIGS. a semiconductor silicon die 7 on which is provided an integrated circuit is housed and constrained on the central portion of a lead frame 4 provided by means of a thin metal lamination.

The chip and the frame are in contact along the semiconductor substrate surface while the integrated circuit is exposed on the open surface of the chip. The central portion of the frame is connected also to the heatsink 5 on the side opposite the chip.

A variation of this process provides that the dissipator be connected directly to the silicon chip without interposition of the frame. In this case the frame is constrained anyway to the dissipator around the chip, e.g. as described in European patent application no. 545007 of this applicant.

In the frame are also formed in the same piece multiple connectors consisting essentially of contact pins which, after conclusion of the production process, allow assembling the package on a printed electronic card. Around the periphery of the semiconductor chip are provided electrical contact pads 3 to which lead portions of the circuitry structure. Said electrical contact pads 3 and the internal ends of the corresponding pins are connected by bonding of thin metal interconnection wires 8.

Lastly, the metal frame with the integrated circuit and the dissipator are protected by a monolithic body-shell 2 provided by injection moulding with an electrically insulating material, e.g. an epoxy resin.

In accordance with the "drop-in" technique the heatsink is let fall on the bottom of a recess made in a half-shell of a die for injection of the heat-hardening resin. The supporting frame for the semiconductor circuit is rested on the edges of the recess in such a manner that the central portion, slightly lowered, comes in contact with the dissipator.

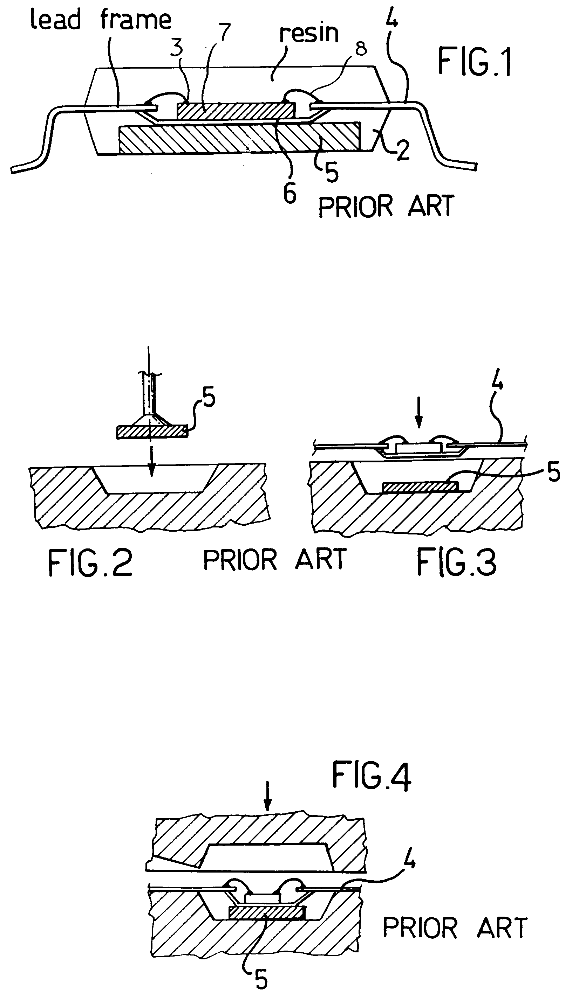

There are performed bonding of the connecting wires and the second half-shell is set on the first to allow injection of the resin and production of the package as shown in FIGS. 2 to 4.

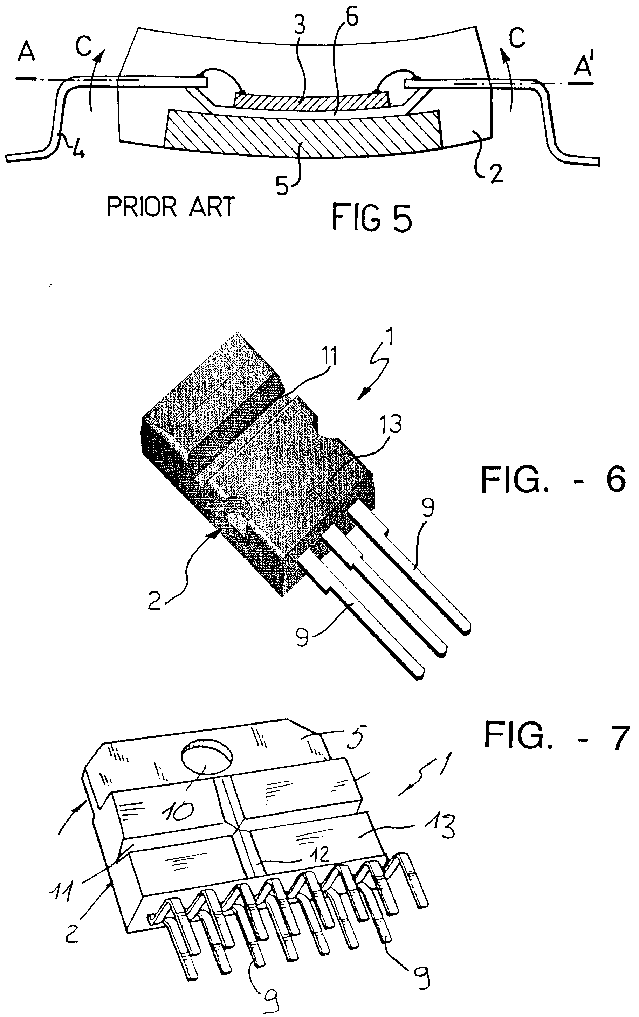

After moulding, the package has a form shown schematically in cross section in FIG. 5 in which it can be seen that the different tensile stresses to which are subject the different materials involved in the production process cause compression in the direction indicated by the arrows C. Basically, the ideal plane occupied by the supporting conductor frame and shown schematically by the A-A' axis undergoes bending whose consequences can be very serious for the reliability and useful life of the device.

Even the relatively high pressure exerted in the step of mounting on the dissipator can damage the chip. This takes place surely every time the surface of the dissipator is not perfectly planar.

It was also possible to determine that the phase of solidification of the heat-hardening resin causes bending moments at the edges of the package and said bending moments are particularly serious in packages having a high height-to-width ratio. In such case the chip of the integrated circuit can break and make the device unserviceable or the contact between the chip and the dissipator can break and make heat dissipation less effective with consequent reduction of the useful life of the circuit.

The technical problem underlying the present invention is to conceive an improved package having structural and functional characteristics such as to increase the reliability and useful life thereof by going beyond the limitations of the solutions presently proposed by the known art.

### Summary of the invention

The solution idea underlying the present invention is based on the assumption that the thicker the resin over the chip the greater will be the tensile stresses which in the phase of solidification of the heat-hardening resin cause bending of the package. It is necessary therefore to conceive a solution allowing the heat-hardening shell to absorb these tensile stresses.

On the basis of this solution idea the technical problem is solved by a package of the type indicated above and defined in the characterising part of the annexed claims.

The technical problem is also solved by a method of increasing the reliability of a semiconductor package as defined in claim 10.

The characteristics and advantages of the package in accordance with the present invention are set forth in the description of an embodiment thereof given below by way of non-limiting example with reference to the annexed drawings.

### Brief description of the drawings

In the drawings:
FIG. 1 shows in enlarged scale a schematic view of a longitudinal cross section of a semiconductor package provided in accordance with the known art,
FIGS. 2 to 4 show schematically and in cross section separate steps of a production process of known type leading to the embodiment of the package of FIG. 1,
FIG. 5 shows in greater detail the structure of the package of FIG. 1,
FIG. 6 shows a perspective view of a package provided in accordance with the present invention, and
FIG. 7 shows another perspective view of a second embodiment of the package of FIG. 6.

With reference to the figures reference number 1 indicates as a whole and schematically a power package provided in accordance with the present invention.

The package 1 incorporates in a body-shell 2 of synthetic plastic material at least one electronic circuit integrated on a semiconductor and mounted on a lead frame 4 and a heatsink 5 in contact with the circuit. The heatsink 5 is projecting from the body-shell 2 and comprises a through hole 10 for fastening to an optional dissipation plate as shown in FIG. 7.

The circuit is provided on a semiconductor silicon die 7 housed and constrained on a central portion 6 of the lead frame 4 provided by means of a thin metal lamination.

The semiconductor silicon die 7 and the lead frame 4 are in contact along the surface of the semiconductor substrate while the integrated circuit is exposed on the open surface of the chip. The semiconductor silicon die 7 can however be in contact directly with the heatsink 5 and in this case the lead frame 4 is constrained to the heatsink 5 peripherally around the semiconductor silicon die 7.

In the lead frame 4 are formed in the same piece multiple connectors consisting essentially of contact pins 9 which after conclusion of the production process allow mounting and connecting of the semiconductor circuit on a printed electronic card. Peripherally to the semiconductor silicon die 7 are provided predetermined contact points 3 to which lead terminations of the circuitry structure. Between said contact points 3 and the internal ends of the corresponding contact pins 9 are connected thin metal wires 8.

Advantageously in accordance with the present invention the body-shell 2 comprises a groove 11 formed transversely on a surface 13 of said body. This groove 11 has a depth less than the distance between the surface 13 and the semiconductor silicon die 7 incorporated in the package.

Said groove 11 has preferably a V cross section but nothing prevents providing it with a U cross section, a square cross section or with any other appropriate cross section. In any case, a groove with a rounded bottom profile would limit dust accumulation.

The groove 11 is formed in a nearly central region of the body-shell 2 compatibly with the position of the underlying thin metal interconnection wires 8. In other words, the groove 11 must not interfere with the thin metal interconnection wires 8 between the semiconductor silicon die 7 and the contact pins 9.

Advantageously the body-shell 2 comprises also a second groove 12 intersecting the above groove 11.

The cross section of this second groove 12 can correspond to that of the first groove 11 or can have a different type of cross section.

In a preferred embodiment the second groove 12 extends perpendicularly to the above on the same surface 13 and in the basically longitudinal direction of the package.

The groove 11 reduces substantially the thickness of the resin layer over the silicon semiconductor silicon die 7. This allows reducing the stress caused by the bending moments applied at the edges of the package and due to the phase of solidification of the heat-hardening resin forming the body-shell 2.

From the above description it is clear that the package in accordance with the present invention solves the technical problem and achieves numerous advantages the first of which is the fact that less mechanical stress is transferred to the semiconductor chip incorporating the integrated circuit.

Basically the present invention allows absorption of the tensile stresses which can damage the integrated circuit during solidification of the heat-hardening resin.

The structure of the package in accordance with the present invention also helps the setting of automatic assembly devices which can make use of the groove to firmly retain the package during various assembly operations.

It is clear that modification, integration and replacement of elements can be made to the package described above by way of nonlimiting example without thereby going beyond the protective scope of the following claims.

## Claims

1. Power package of the type comprising in a body-shell (2) of synthetic plastic material at least one electronic circuit provided on a semiconductor chip (7) fastened on a lead frame (4) or on a heatsink (5) in contact with said lead frame (4) and characterised in that said body-shell (2) of synthetic plastic material exhibits at least one surface groove (11).

2. Package in accordance with claim 1 characterised in that said groove extends transversely.

3. Package in accordance with claim 1 characterised in that said groove (11) has a cross section in the form of the letter V.

4. Package in accordance with claim 1 characterised in that said groove (11) has a cross section in the form of the letter U.

5. Package in accordance with claim 1 characterised in that it comprises at least one second groove (12) on the surface intersecting the previous groove (11).

6. Package in accordance with claim 5 characterised in that said second groove (12) extends longitudinally.

7. Package in accordance with claim 5 characterised in that said grooves (11, 12) extend along directions mutually perpendicular.

8. Package in accordance with claim 1 characterised in that said groove is formed on a surface (13) of the body-shell (2) in a nearly central position.

9. Package in accordance with claim 8 characterised in that said groove (11) has a depth less than the distance between said surface (13) and the semiconductor chip (7) incorporated in the package.

10. Method for providing a semiconductor package comprising in a body-shell (2) of synthetic plastic material at least one electronic circuit provided on a semiconductor chip (7) fastened on a lead frame (4) or on a heatsink (5) in contact with said lead frame (4) and characterised in that it provides in said body-shell (2) of synthetic plastic material at least one surface groove (11).
